# NEW EUROPEAN PATENT SPECIFICATION

(11) **EP 0 842 306 B2**
(45) Date of publication and mention of the opposition decision: **08.06.2005**
(45) Mention of the grant of the patent: 19.01.2000
(21) Application number: 96924987.9
(22) Date of filing: 18.07.1996
(51) Int. Cl.: C23C 14/06, C23C 14/56, C23C 14/02, C23C 14/34, C23C 28/00

(54) **Improvements in and relating to methods for improving the sputter desposition of metal-sulphur coatings, e.g. molybdenum disulphide coatings and to improved coatings**
Verbesserungen in und betreffend Verfahren zur Verbesserung der Sputterabscheidung von Metall-Schwefel-Beschichtungen, z.B. Molybdändisulfid Beschichtungen und verbesserten Beschichtungen
Améliorations des et relatives à des procédés pour améliorer la pulvérisation cathodique d'un revêtement de sulfure de métal, par exemple des revêtements de sulfure de molybdène et à des revêtements améliorés

(30) Priority: 19.07.1995 GB 9514773
(43) Date of publication of application: 20.05.1998
(73) Proprietor: TEER COATINGS LIMITED, Hartlebury, Worcester WR10 4JB (GB)
(72) Inventor: TEER, Dennis, Gerald, Shrawley, Worcestershire WR6 6TD (GB); BELLIDO-GONZALEZ, Victor, Halesowen, West Midlands B62 8ST (GB); HAMPSHIRE, Joanne, Helen, Kidderminster, Worcestershire DY10 3YX (GB)
(74) Representative: Wood, Graham
(86) International application number: PCT/GB1996/001718
(87) International publication number: WO 1997/004142

(56) References cited:
- EP-A- 0 198 459
- EP-A- 0 534 905
- EP-A- 0 562 400
- DD-A- 202 898
- DE-A- 3 516 933
- DE-C- 4 414 051
- FR-A- 2 586 430
- US-A- 4 424 101
- US-A- 4 591 418
- US-A- 5 002 798
- US-A- 5 268 216
- JOURNAL OF VACUUM SCIENCE & TECHNOLOGY A (VACUUM, SURFACES, AND FILMS), JAN.-FEB. 1993, USA, vol. 11, no. 1, ISSN 0734-2101, pages 136-142, XP000345534 ADIBI F ET AL: "Design and characterization of a compact two-target ultrahigh vacuum magnetron sputter deposition system: application to the growth of epitaxial Ti/sub 1-x/Al/sub x/N alloys and TiN/Ti/sub 1-x/Al/sub x/N superlattices"
- PATENT ABSTRACTS OF JAPAN vol. 015, no. 130 (E-1051), 29 March 1991 & JP,A,03 014227 (SHARP CORP), 22 January 1991,
- THIN SOLID FILMS, 25 FEB. 1993, SWITZERLAND, vol. 224, no. 1, ISSN 0040-6090, pages 52-57, XP000354980 GROSSEAU-POUSSARD J L ET AL: "Microstructural and tribological characterization of MoS/sub x/ coatings produced by high-energy ion-beam-assisted deposition"
- PATENT ABSTRACTS OF JAPAN vol. 015, no. 282 (C-0850), 17 July 1991 & JP,A,03 097855 (SHIMADZU CORP), 23 April 1991,
- THIN SOLID FILMS, 15 MAY 1995, SWITZERLAND, vol. 260, no. 2, ISSN 0040-6090, pages 143-147, XP000511901 SEITZMAN L E ET AL: "Effects of temperature and ion-to-atom ratio on the orientation of IBAD MoS/sub 2/ coatings"
- Bernard C. Stupp, 1981, "Synergistic Effects of Metals co-sputtered with MoS2"
- Adibi et al., "Design and characterization of a compact two-target ultrahigh vacuum magnetron sputter deposition system: Application to the growth of epitaxial Ti1-xAIxN alloys and TiN/Ti1-xAIxN superlattices", Journal of Vacuum Science and Technology, Jan/Feb 1993, pages 136 to 142

## Description

This invention relates to improvements in techniques for depositing coatings, such as metal-sulphur coatings, for example MoS₂ and/or WS₂ coatings, and also relates to coatings with improved properties.

MoS₂ coating have been used as solid lubricants in a variety of applications, but mostly as coatings on bearings in aerospace applications.

More recently, MoS₂ coatings have been used to improve the efficiency of cutting tools. (German Patents 982616, or DE 2 345 355, and 4414051 C1, U.S. Patent Application 07 946 642, and Swiss Patent Application 2893/91).

MoS₂ coatings can be deposited by various methods but the preferred method is sputtering. In the past MoS₂ coatings deposited by sputtering have been poorly adhered, of low density, with columnar structure, and the basal planes have been oriented normal to the substrate surface.

Recent developments at Teer Coatings using Closed Field Unbalanced Magnetron Sputter lon Plating (CFUBMSIP) have produced MoS₂ coatings of improved quality. In particular, the coatings are highly adherent, have a dense structure and the basal planes are oriented parallel to the substrate surface. These coatings have the properties required for good tribological performance.

Our earlier patent application EP 0 521 045 discloses a closed field unbalanced Magnetron Sputter ion plating system suitable for performing the present invention, and its contents are hereby incorporated by reference. The reader is directed to read EP 0 521 045 now to appreciate the disclosure incorporated. ("Closed Field" Magnetron Sputter Ion plating is the use of flux linking between adjacent magnetrons to provide a closed magnetic field between them, reducing the number of ionising electrons that escape from the system).

It has been found in practice that when using the sputtering method the results can be variable and that good coatings can be produced in one deposition sequence but that in another deposition sequence which is intended to give identical results, a coating with inferior properties is deposited.

We have linked this variability with the condition of the coating system and the condition of the MoS₂ sputtering target, and in particular with the presence of contaminants in the deposition system. Two contaminants causing problems are water vapour from the atmosphere and Sulphur which is present in the chamber from previous MoS₂ depositions. The source of water contamination is the humidity in the atmosphere. This can be absorbed on all surfaces within the coating chamber but in particular is readily absorbed by the MoS₂ sputtering target.

Sulphur may also be present in the sputtering chamber following previous coating operations and can form compounds such as H₂S which also contribute to contamination. The water vapour and/or the sulphur in the sputtering chamber can cause contamination on the substrate surface prior to deposition leading to coatings with poor adhesion. Water vapour and/or sulphur compounds can also cause contamination during coating. The contaminants can lead to coatings with less desirable properties. For instance brittle coatings may be deposited due to the presence of contaminants.

The aims of the present invention are two-fold: firstly to eliminate or reduce contamination so that coatings of a consistently high quality are deposited, and secondly to improve the coating properties.

The basis of the new method is the use of a second sputter target (or targets) as well as the metal/sulphur target (or targets) (e.g. metal sulphide such as MoS₂ or WS₂).

During the ion cleaning of the substrates which precedes the deposition process in the ion plating technique, we introduce the concept of energising the second target of (eg) Titanium.

We energise the titanium target for two reasons. Firstly in order to be able to strike an intense discharge to the substrates at a low argon pressure so that we ion clean the substrates efficiently at low argon pressure. Secondly we energise the Ti target to mop up the water vapour which is absorbed by the MoS₂ target and also by the MoS₂ previously deposited on the chamber walls, and the sulphur compounds (eg H₂S) which remain in the chamber following previous depositions. This mopping up or gettering of the water vapour and sulphur compounds during the ion cleaning part of the process helps to create very good adhesion between coating and substrate. It also reduces contamination during deposition which can cause brittleness and other undesirable properties.

We obtain an improvement in the adhesion of the coating which is a function of the ion cleaning.

Since making the present invention we have become aware of some prior art (the results of an EPO search). The results of the search support the inventiveness of the present invention.

JP 3 014 227 is perhaps the most relevant document. This discloses a method of making semiconductor devices (a different field from low-friction coatings) in which a titanium target is energised in an argon atmosphere cleaning stage of operation. The Argon atmosphere is cleaned in the sputtering chamber prior to sputtering on to an aluminium substrate. The document is concerned solely with purifying the argon gas, not the aluminium target (aluminium is not a source of contamination). In our invention the target to provide the coating (MoS₂) is a cause of the water vapour problem and a source of sulphur contamination. JP 3014227 does not have an ion cleaning stage of the system to bombard the substrate to be coated with ions prior to coating. It is not even an ion plating system (just sputtering, no ion plating acceleration of ions onto the substrate).

The aluminium alloy of JP 3014227 is not a layer lattice and there is no question of arranging for parallel basal plane orientation of the coating (as we achieve - see later).

JP3014227 does not envisage cleaning the substrate to be coated and the target of coating material with ion cleaning (prior to ion plating the substrate) in order to remove impurities associated with the target. Moreover, it does not suggest using its Titanium target to reduce the argon pressure necessary to ion clean (it does not ion clean).

DE-C- 4414051 discloses a sputtering technique in which MoS₂ is deposited on an interlayer of either Cr₃Si or Cr. It does not discuss ion cleaning or ion plating. It does not have a second target of metal (eg Titanium).

DD-A-202898 discusses depositing MoS₂ on cutting tools, but does not discuss using a second metal target in impurity gettering stage, prior to ion cleaning a substrate before ion plating it.

DE-A-3516933 recognises that the presence of water vapour in the argon atmosphere is deleterious and describes a way of removing it from the gas atmosphere, but is not concerned with removing impurities from a plating chamber.

JP-A-03097855 shows a way of purifying argon gas prior to introducing to its sputter chamber. If used on MoS₂ systems the purified argon gas would only be re-contaminated when it was introduced into the sputter chamber (because the MoS₂ in the chamber has water vapour impurities, and other sulphur impurities would exist in the chamber). JP-A-03097855 shows that although a problem had been appreciated they had not thought of the present invention. Its effect is similar to De-A-3516933 in this respect.

EP-A-0534905 is equivalent to CH2893/91 referred to earlier, and merely discusses the desirability of MoS₂ coatings. It has little relevance to the present invention which is concerned with being able to provide good coatings with repeatability and fewer inconsistencies.

US-A-5002798 is concerned with depositing MoS₂ coatings, but was a totally different technique: it is not magnetron sputter ion plating.

FR-A-2586430 discusses the desirability of low friction coatings on articles such as skis, and using vapour phase deposition techniques, but does not discuss magnetron sputter ion plating, or ways of reducing impurities in MoS₂ coatings.

Preferably the first target is MoS₂ or WS₂. Preferably the metal second target is made of titanium.

The first and second targets are preferably each separately energisable (e.g. each have their own associated magnetron, which have independently controllable power supplies).

The system is capable of being activated in a cleaning operation in which the second target is energised. The first (e.g. MoS₂) target can be energised but is preferably not energised during the ion cleaning operation.

Preferably the first target comprises a magnetron with a target element, as may the second target. The, one, or both, magnetrons may be unbalanced.

In a MSIP system the cleaning operation involves the bombardment of the substrates by ions (usually argon ions) and in the new arrangement also involves the bombardment of the second target with ions so as to produce metal neutrals and ions in the sputter chamber, the metal neutrals and ions react with any impurities in the atmosphere of the chamber so as to remove them from the atmosphere. The metal neutrals and ions may adhere to the walls of the chamber. For example, water and sulphur in the coating chamber atmosphere react with the metal, preferably titanium, created from the second target, to form stable and non-contaminating compounds, during the cleaning operation. The ion bombardment, and the metal atmosphere created in the cleaning operation, help to react deposits of impurities left over from earlier coating operations. This improves the efficiency of the ion cleaning of the substrate and improves the quality of coating that is laid down.

According to a first aspect of the invention we provide a method of improving the sputter depositing of a coating onto a substrate, such as MoS2 coatings, comprising operating a sputter ion plating system in cleaning operation prior to a coating operation, the sputter ion plating system having a first magnetron with a target of MoS2 or WS2 to be coated onto the substrate and a second, magnetron with a cleaning target of reactive metal selected from titanium, vanadium, chromium, zirconium, niobium, molybdenum, tantalum, hafnium, or tungsten, and in which, in the cleaning operation the second target is energized to produce a flux of reactive cleaning metal which reacts with impurities in the sputter chamber so as to remove them from having an active presence during the ion bombardment cleaning of the substrate and in the coating operation, and in the coating operation the first and second targets are selectively energized and as the initial part of the coating operation a layer of the reactive metal is deposited on the substrate followed by the energisation of the first and second targets to deposit material simultaneously on the substrate, a bias voltage is applied to the substrate throughout the cleaning and coating operations and the level of bias voltage applied during the cleaning operation is reduced to a lower bias voltage level during the coating operation.

At least some of the reactive cleaning metal may be ionised metal, but the metal is not necessarily ionised. It could simply be sputtered metal. In one embodiment the reactive cleaning metal is partially ionised (perhaps about 5% ionised).

Preferably the second target is titanium.

The first and second targets have a respective associated magnetron.

The method includeshaving some of the metal of the second target incorporated into the layer that is deposited on the substrate to be coated.

The method may include introducing to the sputter chamber in the coating operation a further material which is incorporated in the coating. The further material is preferably gaseous at its point of introduction and may be nitrogen, or oxygen, or a hydrocarbon gas.

Water and/or sulphur in the sputter chamber atmosphere reacts with the metal, preferably titanium, created from the second target to form stable and non-contaminating compounds during the cleaning operation.

There is provided an article coated using the method of the first aspect of the invention, said coating has an adhesive critical load Lc of 70 N or greater, a Vickers hardness under Vickers Microhardness tests of 500Hv or more, a coefficient of friction of 0.02 or less, a wear resistance to withstand a load of 80 N and a linear speed of 5000mm/min under ball on disc test, using a 6mm steel ball, for a period of 3 hours.

The basal planes of the metal sulphide layer (eg MoS₂) are preferably parallel, or substantially parallel, to the surface of the substrate that they coat.

Preferably the coating is between 0.1µm and 10µm thick, preferably about 1µm thick.

As will be apparent, another advantage of at least some embodiments is that we can reduce impurities when using a magnetron sputter ion plating system to coat an article with a metal sulphide coating by having a target of metal sulphide to produce the coating and a second, different, metal target, and by energising the second target in a cleaning operation before coating commences, the second target (a) producing reactive metal neutrals and ions which getter impurities in the ion plating chamber and also (b) facilitating the generation of an intense discharge at low inert gas pressure (in the ion plating chamber) to achieve better ion cleaning of the substrate to be coated than wou ld be achieved if there were no energised second target.

We also reduce contamination of a coating laid down by a magnetron ion plating system on a substrate by using a first target of material to be deposited that attracts impurities (e.g. water vapour) and by ion cleaning the substrate and the first target in an ion cleaning operation, prior to a deposition/coating operation, and by ensuring that in the ion cleaning operation a second target of good gettering material is energised to create gettering neutrals or ions of said material which ions or atoms clean the system.

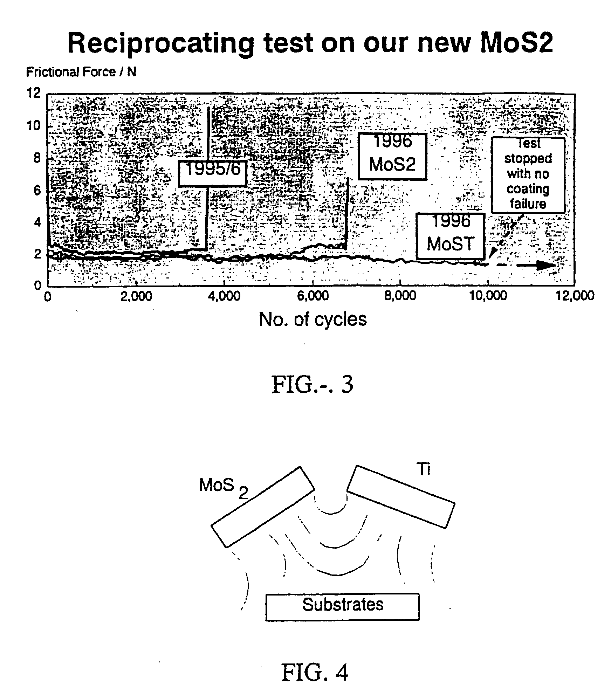

Figure 4 schematically illustrates such a system.

The substrates can be on a moving holder so that they are brought into and moved out of the coating position. The movement is preferably rotary.

It has been found that the coatings produced by the above described methods have a coefficient of friction that is consistently below 0.1, and frequently as low as 0.02.

The method is preferably applied to MSIP, and most preferably CFUBMSIP.

Preferably the article to be coated is rotated about an axis. Preferably the axis of rotation does not pass through the substrate. Alternatively it may pass through the substrate.

An obstruction may be introduced between a target and the substrate if desired.

The obstruction means may at some times hinder the deposition from one target and at other times hinder the deposition from the other target.

The obstruction means may interpose itself in the line of flight of atoms or ions from the target to the substrate to be coated.

Embodiments of the invention will now be described be way of example only with reference to the accompanying drawings of which:-
**Figure 1** shows a CFUBMSIP system having a target of MoS2 and a Titanium target;
**Figures 2 and 3** show test results on MoS2 coatings;
**Figures 4** shows schematically an arrangement of first and second magnetrode electrode sources side by side;
**Figures 5A to 5C** show schematically possible arrangements of dissimilar source electrodes;
**Figure 6** shows another arrangement with three MoS₂ targets and one titanium target;
**Figure 7** illustrates another UBMSIP system which has a barrier between two sources; and
**Figure 8** shows a MSIP system having a reactive metal cleaning target, metal sulphide targets, and a further target of coating material.

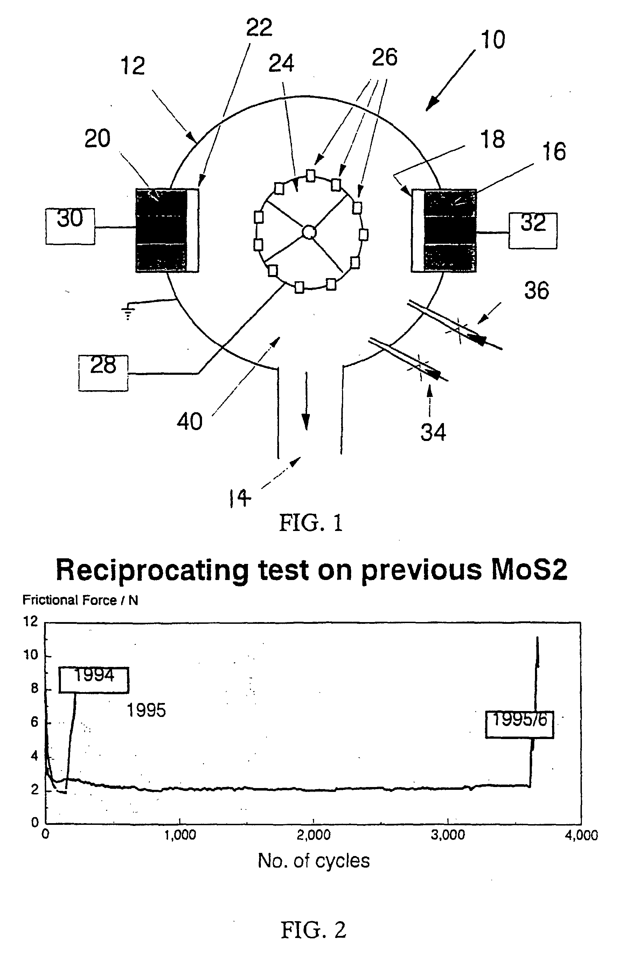

Figure 1 shows an unbalanced magnetron sputter ion plating system 10 having a coating or sputter chamber 12, a pumping port 14, a first magnetron 16 having a MoS₂ target 18, a second magnetron 20 having a titanium target 22, a rotatable component holder 24 holding substrates 26 to be coated, and power supplies 28,30 and 32 for the substrate bias, and first and second magnetrons respectively. There are also two further valved ports 34 and 36 for reactivc and non reactive gases respectively

The preferred deposition method of using the apparatus of Figure 1 is magnetron sputter ion plating and the increase of ion current density produced by using closed field unbalanced magnetron sputter ion plating (UK Patent GB 2 258 343 B) gives improved coating properties. The standard CFUBMSIP is modified and improved by the use of the second target of Ti (or other reactive metal) 22 which is used to getter the impurities in the coating system.

The following describes a typical deposition process, which should be taken only as an example.

The chamber, referenced 40, is evacuated to a pressure lower than 0.067Pa (5x10⁻⁴torr) and preferably to lower than 0.0067Pa (5x10⁻⁵torr) and then is backfilled with argon gas to a pressure of between 0.067Pa to 1.33Pa (5x10⁻⁴torr and 10⁻²torr) and preferably 0.27Pa (2x10⁻³torr). A negative voltage of between 400 and 1000V is applied to the substrates 26 (via the holder 24) and a power of between 50 and 1000W is applied to the titanium target(s) of dimensions 300mmx125mm. Larger targets would require proportionately more power. The substrates are rotated at a speed between 1 and 10rpm.

This ion cleaning stage continues typically for 10 minutes.

For the deposition stage the substrate bias voltage is reduced to a value between floating potential and 75 volts negative and the power to the titanium target(s) is set to a value between zero and 1000W but preferably to 250W and the power to the MoS₂ target(s) is set to about 300W. The power to the MoS₂ targets is not critical and is normally set as high as possible without causing damage to the target. Substrate rotation continues at between 1 and 10rpm during the deposition stage. Deposition continues typically for between 15 minutes and 60 minutes but if thicker coatings are required the coating period is increased.

Between the ion cleaning and deposition stages as described above the sequence can be modified to include the deposition of a thin layer of titanium.

During the deposition stage nitrogen can be introduced to the chamber so as to produce MoS₂/TiN coating rather than the MoS₂/Ti coating.

The deposition method used above is, as will be appreciated a standard magnetron sputter method (MSIP) method or a CFUBMSIP method, with the following exceptions:-

During the ion bombardment cleaning of the substrates the titanium sputter target is energised at a low power. For instance using a target size 12" x 4" a target current of between 0.1 and 0.7amps would be used and preferably the current would be 0.1 or 0.2amps. In another example a current of 2.0amps or 3.0amps also enables the method to work.

During the ion cleaning stage the bias voltage applied to the substrates is sufficiently high to prevent net deposition of titanium onto the substrates and would typically be above 500V negative. The bias during ion cleaning can be DC, RF, AC, or pulsed DC. The titanium sputtered from the titanium target deposits on the chamber walls and reacts with any water vapour and/or sulphur or other contaminants present in the system to create a clean atmosphere for the ion cleaning and for the subsequent deposition.

The energised titanium magnetron target also serves another purpose in that it allows a discharge to be struck to the biased substrate at a lower gas pressure than would be possible without the energised titanium target. This is because of the effect of the magnetic field of the magnetron. Once the Ti magnetron has been energised its plasma provides electrons and ions which initiate (and maintain) the plasma at the substrate.

Following the ion cleaning stage deposition proceeds in the usual way by energising the MoS₂ magnetron target (or targets) at a power selected to give the required deposition rate (this power is not critical) and if a shutter has been used in front of the MoS₂ target, by opening the shutter. For the deposition the bias voltage on the substrates is reduced from that used during ion cleaning, so that net deposition can take place. The substrates can be earthed, floating or at a bias voltage between the floating voltage and 200 volts negative, but are preferably at a voltage of about 45 volts negative. The bias can be DC, RF, AC or pulsed DC. The bias voltage can be reduced after the power to the titanium target is switched off so that only a MoS₂ layer is deposited. The bias voltage can be reduced before the titanium target is switched off and before the MoS₂ target is energised so that a layer of titanium is deposited prior to the MoS₂ coating. During this stage it is also possible to inlet Nitrogen into the system so that a layer of TiN is deposited prior to the MoS₂ coating.

The titanium target remains energised during the deposition of the MoS₂ so that a mixture of titanium and MoS₂ is deposited. The titanium content can be between 0 and 40% but preferably would be 10% or less. It is found that the MoS₂/Titanium mixtures can have as low a coefficient of friction as MoS₂ but with improved mechanical properties and wear resistance.

During this stage it is also possible to maintain a flow of nitrogen gas so that a mixture of Titanium Nitride and MoS₂ is deposited. The TiN content can be between 0 and 40% but preferably would be 10% or less. It is found that the MoS₂/TiN can have as low a coefficient of friction as MoS₂ but with improved mechanical properties and wear resistance.

Thus the possible coatings are:-
A (usually thin) layer of Ti followed by a mixture of MoS₂ with up to 40% titanium (MoS₂/Ti layer).
A (usually thin) layer of TiN followed by a mixture of MoS₂ with up to 40% TiN (MoS₂/TiN layer).

In all cases the ion cleaning takes place with the titanium energised.

The titanium in the above description can be replaced with any metal that also getters the impurities to the extent necessary to achieve a significantly improved performance.

The nitrogen in the above description can be replaced with oxygen or a hydrocarbon gas or mixtures of these gases.

The substrate in the above description can be of any material and can include a substrate already coated with another material.

The MoS₂ or MoS₂/Ti or MoS₂/TiN coatings can have thicknesses from very thin, 0.1µm or less to very thick, 10µm or more, but would preferably be about 1µm. The very thin coatings still give good performance because of the high wear resistance of the coatings. The very thick coatings are useful because the wear rate is approximately uniform throughout the thickness of the coating and therefore they can give very long lives. This is totally unlike MoS₂ deposited by earlier methods where most of the thickness of thick coatings would wear away very quickly and only the last thin coating, about 0.25µm, would provide any useful, wear resistance.

The MoS₂ deposited as described above has very good tribological properties, with significant improvements over previous MoS₂ coatings.

If the MoS₂ is co-deposited with Ti or TiN as described above the tribological properties are further improved.

The co-deposited coatings are deposited by simultaneous deposition from a MoS₂ target and a neighbouring titanium target to produce a coating consisting of a mixture of MoS₂ and Ti(or TiN). (See Figure 4). There may be an ion cleaning titanium target and a separate co-depositing titanium target, or they may be the same target.

Alternatively and preferably the coatings can be deposited in a typical Closed Field Unbalanced Magnetron Sputter Ion Plating System (UK Patent GB 2 258 343 B) in which the substrates are rotated between magnetrons mounted around the substrate rotation axis.

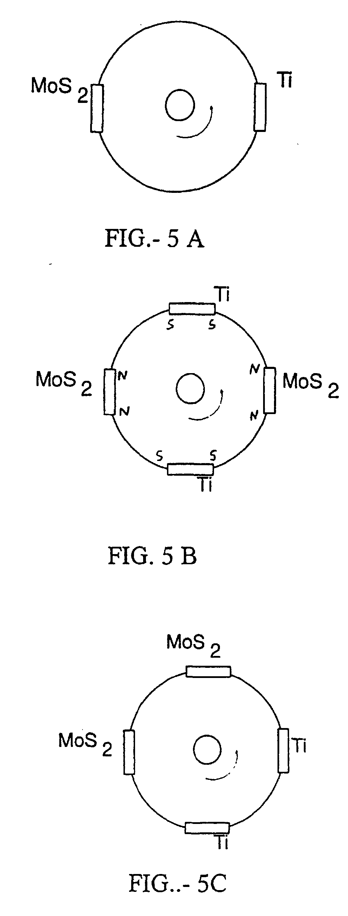

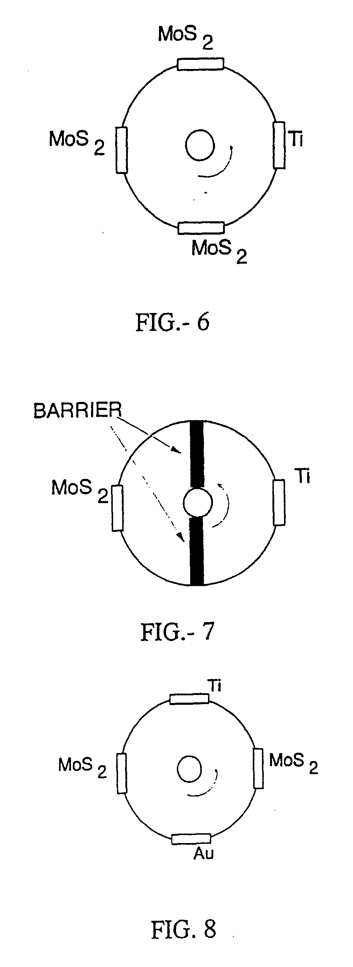

Three possible arrangements are shown in Figures 5a to 5c. A fourth arrangement is shown in Figure 6.

Normally the maximum safe power is applied to the MoS₂ target (or targets) in order to obtain the maximum deposition rate. The maximum safe power is normally about 250W on a 300mm x 125mm target. Although higher powers are possible they can cause cracking in the rather brittle MoS₂ target.

It has been found that the coatings produced by the above described methods have a coefficient of friction consistently below 0.1 and frequently as low as 0.02.

There may be more than one "second" target. They need not necessarily be of the same metal.

It will be appreciated that in the foregoing we could have more than one metal sulphide source (e.g. more than on MoS₂ source or, for example, we could have one MoS₂ source and one WS₂ source). We could have more than one metal source (e.g. more than one Ti source, or a source of one metal and another source of a different metal).

Whilst it might theoretically be possible to replace the MoS₂ (or the like) source with uncompounded sources of the elements we are not aware of such a system working and we would envisage having one or more metal-sulphur compound sources.

We have used the CFUBMSIP system described in UK Patent GB 2 258 343 B to produce very good coatings of MoS₂. We believe that the high ion content density at the substrate to be coated (greater than 1mA/cm²) and the low bias voltage of the substrate to be coated (typically 45 V negative) are factors in the production of good coatings, but they may not be essential. The coating is adherent and has a dense coherent structure. The general tribological properties are extremely good and the coatings also give improved cutting tool performance for several work piece materials, and allow high speed machining, unlubricated or with minimal lubrication.

We coated a high speed steel plate with MoS₂ using our system, with about 10% Titanium in the structure and the results of tests on the coated workpiece are given below:

| | |
|---|---|
| coefficient of friction | generally 0.02. This is very low indeed. Humidity has only a slight effect on the friction. |
| Adhesion | The critical load Lc was greater that 70N. This is very high. |
| Hardness | Vickers Microhardness Tests indicate a hardness of over 500Hv. This very high figure is confirmed by Nano Indentation tests. |
| Wear Resistance | The extreme wear resistance is indicated by ball on disc test results, using a 6mm steel ball, a load of 80N and a linear speed of 5000mm/min. Typically a 1µm thick coating of MoS₂ and titanium on a tool steel substrate is not removed after 3 hours of running. |

Figures 2 and 3 show a comparison with some prior art MoS₂ coatings we have produced. The tests were performed using a Teer ST-2200 reciprocating tester. The load was 100N on a 5mm diameter WC-Co ball. The speed was 150mm/sec with a half period of 1 sec.

It will be seen from Figures 2 and 3 that the life of the coating is considerably more than what we could achieve before the present invention.

Tests also show an improvement in cutting tool performance when they are coated with our new MoS₂ metal composite coating. Drilling tests into Al 15% Si alloys give a life of uncoated HSS drills of about 50 holes. The same HSS drills coated with our MoS₂/Ti composite coating produced over 700 holes without failure.

Many tests have been carried out on carbide cutting tools coated with TiN, TiAlN or other hard coatings followed by a MoS₂ coating. The work piece materials that were machined included cast iron, stainless steel, Al alloys, Mg alloys, and Nickel based alloys. Our MoS₂ coatings produced an improvement in life of at least a factor of two, but in many cases the improvement was even greater.

Significant improvements in performance have been recorded on drills, milling cutters, reamers, saw blades, and turning tools.

Similar improvements have found in relation to forming tools, such as dies and punches.

Improvements have been found in other components such as bearings, gears, automobile engine components, control valves, and other general machine parts.

Our MoS₂ composite coatings which have the properties described above are believed to be new and inventive in their own right. They have a Titanium, or other metal, content. The other metal content may be ½%, 1%, 1½, 2%, 2½%, 3%, 3½, 4%, 5% or higher (by percent of number of atoms in the coating layer). The metal content may be 30% or less, or 10% or less for MoS₂/Ti or MoS₂/TiN coatings.

We can produce composite coatings that have a critical adhesion load of at least 50N, 60N, or at least 70N. The coefficient of friction may be 0.05 or less, or 0.02 or less. The Vickers hardness may be 500HV or more.

We have discovered a further inventive feature. Our MoS₂ composite coating deposited in a typical CFUBMSIP system with substrate rotation is surprisingly hard - about 500 Vickers. This is harder than stainless steel. MoS₂ coatings have previously been soft - it was possible to scratch them off with a fingernail.

When we energise both magnetron electrodes at once (the Titanium and the MoS₂) we have a rotating component holder between them. A sample situated on the component holder cycles itself closer to the Titanium source, equidistant from both Titanium and MoS₂ source, closer to the MoS₂ source, equidistant from both sources, and so on.

Figure 7 illustrates a modified UBMSIP system which has a barrier member, or dividing member, that masks one side of the component holder (at any instant) from the effects of one of the magnetron ion sources.

We may have a third or further electrode(s)/magnetron(s) to provide a third (or further) coating constituent, possibly of another metal or alloy. The third (or further) magnetron may have a metal or carbon (or metallic semi-metal) target, or a compound (eg N,C, or O compound). The mask/barrier member (if provided) may define three (or more) compartments.

We may have a gettering electrode, a first coating material electrode and a second coating material electrode.

We prefer to have three MoS₂ electrodes and one Titanium electrode in a 4 magnetron UBMSIP system, with the magnetrons in the closed field arrangement as described in UK Patent GB 2 258 343 B.

Instead of Titanium we may use another reactivc metal, such as vanadium, chromium, zirconium, niobium, molybdenum, tantalum, hafnium, or tungsten or an unreactive metal, such as gold or platinum.

It will be appreciated that a non-reactive metal will not work for the ion cleaning of the system, but can be used during the deposition (in addition to the reactive metal).

Figure 8 illustrates a MSIP system, which will usually use unbalanced magnetrons, in which there is a reactive metal target (e.g. titanium), two hexagonal layer lattice targets (e.g. MoS₂), and a non-reactive metal target (e.g. gold). The substrate to be coated is rotated by a component holder. The system would preferably be a closed field system (U.K. Patent GB 2 258 343 B)

The reactive metal target is energised in the ion cleaning operation of the system to clean the system by producing gettering ions or neutrals which mop up impurities. During thc coating operation there are different ways that the system can be operated.

Platinum is another non-reactive metal that gives good coating results.

Instead of, or in addition to the gold (or other non-reactive metal) target we may have a carbon target (or other "metallic" non-metal) and produce coatings including carbon.

The carbon may be deposited as diamond-like carbon. Such coatings have also been found to have good hardness, adhesion, and low friction.

Instead of MoS₂ we may use any other hexagonal tayer/lattice metal sulphide material eg WS₂.

The coatings that we make may have a stoichiometric ratio of metal to sulphur (e.g. in MoS₂), or a non-stoichiometric ratio. We may produce a coating with less sulphur in it than the stoichiometric ratio (a sub-stoichiometric composition).

For example a molybdenum sulphur coating may be MoS₂ at the stoichiometric ratio or MoSₓ where x is above or below two. "X" may be about 1.5. X may be from 1.2 to 2.5.

Even if the target of MoS₂ is stoichiometric the coating need not be. We can get a variety of sub stoichiometric coatings in tests.

Thus where in the protection - defining claims of this application we refer to MoS₂ we mean molybdenum/sulphur composition having a hexagonal layer lattice structure (or substantially one) and having stoichiometric or non-stoichiometric composition.

It will be appreciated that the heart of the cleaning process is that during a normal deposition sequence the surfaces of the substrates are cleaning by ion bombardment. The ions are produced by applying a high (typically 1000V) negative bias to the substrates in an atmosphere of argon gas at a pressure of about 0.27Pa (2 x 10⁻³ torr). The argon ion bombardment is aided here by the operation of the second electrode which produces a flux of reactive metal into the chamber and which removes contaminants from the atmosphere in the chamber. We bombard the substrates using argon ions as in a conventional process, and the reactive metal flux from the 2nd electrode is cleaning up the atmosphere in this process and thus making it more effective.

## Claims

1. A method of improving the sputter depositing of a coating onto a substrate, such as MoS2 coatings, comprising operating a sputter ion plating system in cleaning operation prior to a coating operation, the sputter ion plating system having a first magnetron with a target of MoS2 or WS2 to be coated onto the substrate and a second, magnetron with a cleaning target of reactive metal selected from titanium, vanadium, chromium, zirconium, niobium, molybdenum, tantalum, hafnium, or tungsten, and in which, in the cleaning operation the second target is energized to produce a flux of reactive cleaning metal which reacts with impurities in the sputter chamber so as to remove them from having an active presence during the ion bombardment cleaning of the substrate and in the coating operation, and in the coating operation the first and second targets are selectively energized and as the initial part of the coating operation a layer of the reactive metal is deposited on the substrate followed by the energisation of the first and second targets to deposit material simultaneously on the substrate, a bias voltage is applied to the substrate throughout the cleaning and coating operations and the level of bias voltage applied during the cleaning operation is reduced to a lower bias voltage level during the coating operation.

2. A method according to claim 1 in which at least some of the reactive cleaning metal is ionised metal.

3. A method according to claim 1 in which at least some of the reactive cleaning metal is a sputtered, unionised, metal.

4. A method according to any one of claims 1 to 3 which is practised in a magnetron sputter Ion Plating system which is adapted to operate in use such that the cleaning operation involves the bombardment of the substrates to be coated by ions and also involves the bombardment of the second target with ions so as to create metal ions or sputtered atoms from the second target in the sputter chamber, the metal ions or sputtered atoms cleaning the walls of the chamber and reacting with impurities in the atmosphere of the chamber so as to remove the impurities from the system.

5. A method according to any one of claims 1 to 4 in which water and/or sulphur in the sputter chamber atmosphere react with the metal, preferably titanium or another reactive metal, created from the second target to form stable and non-contaminating compounds during the cleaning operation.

6. A method according to any one of claims 1 to 5 which includes the step of introducing to the sputter chamber in the coating operation a further material which is incorporated in the coating.

7. A method according to claim 6 in which the further material is gaseous at its point of introduction, and may be nitrogen or oxygen, or a hydrocarbon gas.

8. A method according to claim 6 in which the further material is a metal, such as titanium vanadium, chromium, zirconium, niobium, tantalum, hafnium, tungsten, gold or platinum.

9. A method according to any one of claims 1 to 8 which further comprises laying down a first and a second layer, in which the first layer comprises one of: titanium or another metal, or titanium nitride or another metal nitride and in which the second layer comprises molybdenum disulphide or other hexagonal layer lattice material; or a mixture of molybdenum disulphide or other hexagonal layer lattice material and a metal; or a mixture of molybdenum disulphide or other hexagonal layer lattice material and a metal nitride.

10. A method according to any one of claims 1 to 9 in which the coating is between 0.1µm and 10µm thick, preferably about 1µm thick.

11. An article coated using the method of any one of claims 1 to 10 **characterised in that** the coating has an adhesive critical load Lc of 70 N or greater, a Vickers hardness under Vickers Microhardness tests of 500Hv or more, a coefficient of friction of 0.02 or less, a wear resistance to withstand a load of 80 N and a linear speed of 5000mm/min under ball on disc test, using a 6mm steel ball, for a period of 3 hours.

12. An article according to claim 11 which has a coating of a mixture of MoS₂/Ti, or MoS₂/TiN.

13. An article according to claim 12 in which the MoS₂/Ti or MoS₂/TiN, coating has a Ti, TiN, content of 10% or less, or 30% or less by % of those atoms/compounds in the total number of atoms of the coating - atomic percent.

14. An article according to any one of claims 11 to 13 in which the basal planes of the metal sulphide layer are parallel, or substantially parallel, to the surface of the substrate that they coat.

15. An article according to any one of claims 11 to 14 in which the coating is not a homogeneous layer but instead has layers of different composition which vary cyclically; one kind of layer comprising hexagonal layer/lattice material and another kind of layer comprising metal or semi-metal, the two sets of layers alternating.

## Patentansprüche

1. Verfahren zum Verbessern des Aufstäubens einer Beschichtung, wie z.B. MoS2-Beschichtungen, auf ein Substrat, das die folgenden Schritte umfasst: Betreiben eines Sputterionenplattiersystems im Reinigungsbetrieb vor einem Beschichtungsbetrieb, wobei das Sputterionenplattiersystem ein erstes Magnetron mit einem Target aus MoS2 oder WS2, das auf das Substrat aufgetragen werden soll, und ein zweites Magnetron mit einem Reinigungstarget aus reaktivem Metall aufweist, ausgewählt aus Titan, Vanadium, Chrom, Zirkonium, Niob, Molybdän, Tantal, Hafnium oder Wolfram, wobei während des Reinigungsbetriebs das zweite Target erregt wird, um einen Fluss von reaktivem Reinigungsmetall zu erzeugen, das mit Verunreinigungen in der Zerstäubungskammer reagiert, um zu verhindern, dass diese während der Ionenbombardierungsreinigung des Substrats und beim Beschichtungsbetrieb eine aktive Präsenz haben, und während des Beschichtungsbetriebs das erste und das zweite Target selektiv erregt werden, und als Anfangsteil des Beschichtungsbetriebs eine Schicht des reaktiven Metalls auf das Substrat aufgebracht wird, worauf die Erregung des ersten und zweiten Targets folgt, um Material gleichzeitig auf das Substrat aufzutragen, wobei während der Reinigungs- und Beschichtungsvorgänge eine Vorspannung an das Substrat angelegt wird, wobei der Pegel der Vorspannung, die während des Reinigungsbetriebs angelegt wird, auf einen tieferen Vorspannungspegel während des Beschichtungsbetriebs reduziert wird.

2. Verfahren nach Anspruch 1, bei dem wenigstens ein Teil des reaktiven Reinigungsmaterials ionisiertes Metall ist.

3. Verfahren nach Anspruch 1, bei dem wenigstens ein Teil des reaktiven Reinigungsmaterials ein zerstäubtes, nichtionisiertes Metall ist.

4. Verfahren nach einem der Ansprüche 1 bis 3, das in einem Magnetron-Sputterionenplattiersystem ausgeführt wird, das so gestaltet ist, dass es beim Gebrauch so arbeitet, dass der Reinigungsvorgang die Bombardierung der mit Ionen zu beschichtenden Substrate beinhaltet und auch die Bombardierung des zweiten Targets mit Ionen beinhaltet, um Metallionen oder zerstäubte Atome von dem zweiten Target in der Zerstäubungskammer zu erzeugen, wobei die Metallionen oder zerstäubten Atome die Wände der Kammer reinigen und mit Verunreinigungen in der Atmosphäre der Kammer reagieren, um die Verunreinigungen aus dem System zu beseitigen.

5. Verfahren nach einem der Ansprüche 1 bis 4, bei dem Wasser und/oder Schwefel in der Zerstäubungskammeratmosphäre mit dem Metall, vorzugsweise Titan oder einem anderen reaktiven Metall, reagiert/reagieren, das von dem zweiten Target erzeugt wird, um während des Reinigungsvorgangs stabile und nicht kontaminierende Verbindungen zu bilden.

6. Verfahren nach einem der Ansprüche 1 bis 5, das den Schritt des Einleitens eines weiteren Materials, das in der Beschichtung enthalten ist, in die Zerstäubungskammer während des Beschichtungsbetriebs beinhaltet.

7. Verfahren nach Anspruch 6, wobei das weitere Material an diesem Punkt des Einleitens gasförmig ist und Stickstoff oder Sauerstoff oder ein Kohlenwasserstoffgas sein kann.

8. Verfahren nach Anspruch 6, wobei das weitere Material ein Metall wie z.B. Titan, Vanadium, Chrom, Zirkonium, Niob, Tantal, Hafnium, Wolfram, Gold oder Platin ist.

9. Verfahren nach einem der Ansprüche 1 bis 8, das ferner das Auftragen einer ersten und einer zweiten Schicht umfasst, wobei die erste Schicht entweder Titan oder ein anderes Metall oder Titannitrid oder ein anderes Metallnitrid umfasst, und wobei die zweite Schicht Molybdändisulfid oder ein anderes hexagonales Schicht-Gittermaterial; oder ein Gemisch aus Molybdändisulfid oder einem anderen hexagonalen Schicht-Gittermaterial und einem Metall; oder ein Gemisch aus Molybdändisulfid oder einem anderen hexagonalen Schicht-Gittermaterial und einem Metallnitrid umfasst.

10. Verfahren nach einem der Ansprüche 1 bis 9, bei dem die Beschichtung eine Dicke zwischen 0,1 µm und 10 µm, vorzugsweise von etwa 1 µm hat.

11. Artikel, beschichtet mit dem Verfahren nach einem der Ansprüche 1 bis 10, **dadurch gekennzeichnet, dass** die Beschichtung eine Haftungsgrenzlast Lc von 70 N oder höher, eine Vickers-Härte gemäß dem Vickers-Mikrohärtetest von 500 Hv oder mehr, einen Reibungskoeffizienten von 0,02 oder weniger, eine Verschleißbeständigkeit zum Widerstehen einer Last von 80 N und eine Lineargeschwindigkeit von 5000 mm/min unter einem Kugel-auf-Scheibe-Test unter Verwendung einer 6 mm Stahlkugel über einen Zeitraum von 3 Stunden hat.

12. Artikel nach Anspruch 11, der eine Beschichtung aus einem Gemisch aus MoS₂/Ti oder MoS₂/TiN hat.

13. Artikel nach Anspruch 12, bei dem die Beschichtung aus MoS₂/Ti oder MoS₂/TiN einen Ti-, TiN-Gehalt von 10% oder weniger oder 30% oder weniger gemäß dem Prozentanteil dieser Atome/Verbindungen an der Gesamtzahl der Atome der Atomprozent der Beschichtung hat.

14. Artikel nach einem der Ansprüche 11 bis 13, bei dem die Grundflächen der Metallsulfidschicht parallel oder im Wesentlichen parallel zur Oberfläche des Substrats sind, das sie beschichten.

15. Artikel nach einem der Ansprüche 11 bis 14, bei dem die Beschichtung keine homogene Schicht ist, sondern stattdessen Schichten unterschiedlicher Zusammensetzungen hat, die zyklisch variieren; wobei eine Art von Schicht ein hexagonales Schicht-/Gittermaterial und eine andere Art von Schicht Metall oder Halbmetall umfasst, wobei die beiden Schichtsätze abwechseln.

## Revendications

1. Procédé d'amélioration du dépôt par pulvérisation d'un revêtement sur un substrat, par exemple des revêtements de MoS₂, comprenant l'actionnement d'un système de placage ionique par pulvérisation dans le cadre de l'opération de nettoyage effectuée avant une opération d'application du revêtement, le système de placage ionique par pulvérisation possédant un premier magnétron avec une cible de MoS₂ ou de WS₂ destinée à revêtir le substrat, et un deuxième magnétron avec une cible de nettoyage constituée d'un métal actif sélectionné parmi les substances suivantes : titane, vanadium, chrome, zirconium, niobium, molybdène, tantale, hafnium ou tungstène, et dans lequel, lors de l'opération de nettoyage, la deuxième cible est excitée afin de produire un flux de métal actif de nettoyage lequel réagit avec les impuretés présentes dans la chambre de pulvérisation, de sorte à les éliminer pour les empêcher d'avoir une présence active pendant le nettoyage par bombardement ionique du substrat et lors de l'opération d'application du revêtement, et dans le cadre de l'opération d'application du revêtement, la première et la deuxième cibles sont excitées de manière sélective et, en tant que phase initiale de l'opération d'application du revêtement une couche de métal actif est déposée sur le substrat, suivie de l'excitation de la première et de la deuxième cibles afin de déposer simultanément du matériau sur le substrat, une tension de polarisation est appliquée au substrat pendant l'intégralité des opérations de nettoyage et d'application du revêtement, alors que le niveau de tension de polarisation appliqué lors de l'opération de nettoyage est réduit à un niveau de tension de polarisation plus faible pendant l'opération d'application du revêtement.

2. Procédé, selon la revendication 1, dans lequel une certaine quantité au moins du métal actif de nettoyage est constituée de métal ionisé.

3. Procédé, selon la revendication 1, dans lequel une certaine quantité au moins du métal actif de nettoyage est constituée de métal pulvérisé non-ionisé.

4. Procédé, selon l'une quelconque des revendications 1 à 3, qui est mis en pratique dans un système de placage ionique par pulvérisation au magnétron qui est adapté de façon à fonctionner, en utilisation, de sorte que l'opération de nettoyage fasse intervenir le bombardement des substrats à revêtir par des ions, et implique également le bombardement de la deuxième cible avec des ions de sorte à créer des ions métalliques ou des atomes pulvérisés à partir de la deuxième cible dans la chambre de pulvérisation, alors que les ions métalliques ou les atomes pulvérisés nettoient les parois de la chambre et réagissent avec les impuretés présentes dans l'atmosphère de la chambre de sorte à éliminer les impuretés du système.

5. Procédé, selon l'une quelconque des revendications 1 à 4, dans lequel l'eau et/ou le soufre présents dans l'atmosphère de la chambre de pulvérisation réagissent avec le métal, de préférence avec le titane ou un autre métal actif, créé à partir de la deuxième cible afin de former des composés stables et non-contaminants pendant l'opération de nettoyage.

6. Procédé, selon l'une quelconque des revendications 1 à 5, qui inclut l'étape consistant à introduire dans la chambre de pulvérisation, pendant l'opération d'application du revêtement, un matériau supplémentaire qui est incorporé au revêtement.

7. Procédé, selon la revendication 6, dans lequel le matériau supplémentaire est de nature gazeuse, à son point d'introduction, et peut se présenter sous la forme d'azote ou d'oxygène ou bien un gaz d'hydrocarbure.

8. Procédé, selon la revendication 6, dans lequel le matériau supplémentaire est un métal comme le titane, le vanadium, le chrome, le zirconium, le niobium, le tantale, le hafnium, le tungstène, l'or ou le platine.

9. Procédé, selon l'une quelconque des revendications 1 à 8, qui comprend en outre le dépôt d'une première et d'une deuxième couches, dans lequel la première couche l'une des substances suivantes : titane ou un autre métal, ou nitrure de titane ou un autre nitrure métallique, et dans lequel la deuxième couche comprend du bisulfure de molybdène ou un autre matériau réticulé de couche hexagonale ; ou un mélange de bisulfure de molybdène ou autre matériau réticulé de couche hexagonale et un métal ; ou un mélange de bisulfure de molybdène ou un autre matériau réticulé de couche hexagonale et un nitrure métallique.

10. Procédé, selon l'une quelconque des revendications 1 à 9, dans lequel le revêtement a une épaisseur se situant entre 0,1µm et 10µm, de préférence une épaisseur de 1µm environ.

11. Article revêtu à l'aide du procédé de l'une quelconque des revendications 1 à 10, **caractérisé en ce que** le revêtement a une charge critique adhésive Lc de 70 N, ou davantage, une dureté Vickers obtenue lors d'essais de microdureté Vickers de 500 Hv ou davantage, un coefficient de friction de 0,02 ou inférieur à 0,02, une résistance d'usure permettant de résister à une charge de 80 N et une vitesse linéaire de 5000 mm/mn lors d'un essai de bille sur disque faisant intervenir une bille d'acier de 6 mm, pendant une durée de 3 heures.

12. Article, selon la revendication 11, qui possède un revêtement constitué d'un mélange de MoS₂ / Ti ou de MoS₂ / TiN.

13. Article, selon la revendication 12, dans lequel le revêtement de MoS₂ / Ti ou de MoS₂ / TiN a une teneur de Ti, TiN qui est égale à 10%, ou inférieure à 10%, ou bien égale à 30%, ou inférieure à 30%, en termes de pourcentage par rapport aux atomes /composés présents dans le nombre total d'atomes du revêtement - pourcentage atomique.

14. Article, selon l'une quelconque des revendications 11 à 13, dans lequel les plans basaux de la couche de sulfure métallique sont parallèles, ou essentiellement parallèles, par rapport à la surface du substrat dont ils assurent le revêtement.

15. Article, selon l'une quelconque des revendications 11 à 14, dans lequel le revêtement n'est pas une couche homogène, mais comporte à la place des couches de différentes compositions qui varient de façon cyclique ; un type de couche comprenant du matériau réticulé/de couche hexagonale et un autre type de couche comprenant du métal ou du semi-métal, les deux ensembles de couches étant en alternance.
